# EUROPEAN PATENT SPECIFICATION

(11) **EP 1 130 777 B1**
(45) Date of publication and mention of the grant of the patent: **02.07.2008**
(21) Application number: 01301790.0
(22) Date of filing: 27.02.2001
(51) Int. Cl.: H03K 17/725, H03K 17/722, H03K 17/79, H03K 17/13

(54) **Solid state relay**
Halbleiterrelais
Relais à semi-conducteurs

(30) Priority: 29.02.2000 GB 0004618; 19.10.2000 GB 0025608
(43) Date of publication of application: 05.09.2001
(73) Proprietor: Root 2 Limited, Dalgety Bay Dunfermline Fife KY11 9PF (GB)
(72) Inventor: Wonfor, Colin, Dalgety Bay, Dunfermline KY11 9FQ (GB)
(74) Representative: Cooper, John

(56) References cited:
- WO-A-00/08740
- DE-A- 4 026 679
- DE-C- 4 313 882
- GB-A- 2 062 372

## Description

The present invention as it is defined is the independent claim relates to solid state relay circuits.

In general, a relay is an electrical switching device in which operation of the switch is controlled by an electrical control signal applied to the relay. Conventional relays are electromechanical devices. A solid state relay (SSR), on the other hand, is comprised entirely of solid state components and, unlike electromagnetic relays, involves no mechanical movement to provide the required switching operation. An example of solid state relay is disclosed in the document GB-A-2 062 372.

SSRs are commonly used to provide a safe interface between low voltage control circuits and high voltage, high current electrical equipment. Because it has no moving parts and is sealed, the SSR has become an essential component in a wide range of electrical equipment. However, the design of conventional SSRs suffers a serious disadvantage because it switches alternating current (AC) at random points in the sinusoidal waveform, causing bursts of electrical noise to be generated.
Improved designs seek to operate the switch at zero volts in the waveform, but there is still an uncertainty of at least +/- 1.8 volts in the switching voltage, which still produces considerable noise.

The increasing use of computers and other sensitive electronic systems, all of which are sensitive to mains-borne or radiated electrical interference, means that there is an increasing need to control electromagnetic noise such as that generated by SSRs. Existing European standards limit the maximum noise generated by electrical apparatus to 50 decibels (dB) throughout the frequency band of 30MHz to 1000MHz (radiated) and 150KHz to 30 MHz (conducted).

Existing SSR designs fall well short of these standards, generating noise of the order of 120dB at 100kHz and thus requiring the use of complex and expensive filter circuits.

One widely-used SSR design consists of a reversed, back-to-back pair of thyristors triggered by a crude, zero volts sensing device and can normally only be switched on when the voltage across the thyristors is greater than approximately 2V. The energy released by the switching action distorts the AC power waveform, typically by at least 2% at 100V. Such devices also switch on with a steep rise, increasing the harmonic content of the noise generated and so increasing the width of the frequency spectrum affected.

It is an object of the present invention to provide an improved SSR in which the noise generated by operation of the SSR is substantially reduced.

In accordance with a first aspect of the present invention there is provided a solid state relay comprising:
a switch circuit including primary switch means for controlling an AC power supply, said primary switch means including thyristor means; and
a control circuit for receiving a control input signal which controls the operation of said primary switch means; wherein
said switch circuit and said control circuit are electrically isolated from one another and coupled to one another by first and second coupling means, said first coupling means being optical coupling means comprising first light emitting means in said switch circuit and optical switch means in said control circuit responsive to said first light emitting means,
   and said second coupling means comprising signal emitting means in said control circuit and signal receiving means in said switch circuit responsive to said second signal emitting means;
said control circuit includes pilot switch means responsive to said optical switch means and said pilot switch means controls the operation of said second light emitting means;
the light emitted by said first light emitting means varies with the AC supply voltage such that said pilot switch switches on said second signal emitting means at a predetermined AC supply voltage amplitude as said AC supply voltage approaches zero; and
said photo-sensitive means operates in response to said second light emitting means to actuate said primary switching means.

Preferably said primary switching means comprises a pair of inverse back-to-back thyristors.

Alternatively, a pair of inverse back-to-back alternistors may be used.

Further alternatively, a pair of inverse back-to-back triacs may be used.

Optionally, the second coupling means may be magnetic coupling, electrostatic coupling or piezoelectric coupling.

Preferably, said light emitting means comprise Light Emitting Diodes (LEDs).

Preferably, said optical switch comprises a photo-transistor.

Preferably, said second coupling means is an opto-coupling means, said second signal emitting means is a light emitting means and said signal receiving means is a photosensitive means.

More preferably, said photo-sensitive means comprises a photovoltaic cell.

Preferably, said pilot switch means comprises a thyristor.

Preferably, the switch circuit includes secondary switch means responsive to said photo-sensitive means and adapted to trigger said primary switch means and to conduct said AC power supply in parallel with said primary switching means during a time interval between the switching on of said pilot switch and the AC power supply voltage amplitude reaching a predetermined minimum value at which the primary switch means takes over full conduction of the AC power supply.

Preferably, said secondary switch means comprises a pair of gate-source coupled Field Effect Transistors (FETs) having their respective drains connected to the gates of the thyristor means of the primary switch means and first and second diode means connected between the gates of said thyristor means and AC supply terminals of the switch circuit.

Preferably, the operation of said FETs is controlled by said photo-sensitive means.

Preferably, said FETs are power Metal Oxide Semiconductor Field Effect Transistors.

In one embodiment, said diode means comprise Schottky diodes.

In a preferred embodiment, said diode means comprise transistors, the operation of which is controlled by further optical coupling means each comprising light emitting means in the control circuit, the operation of which is controlled by said pilot switch means, and photo-sensitive means (preferably a photovoltaic cell) in the switch circuit.

In accordance with a second aspect of the present invention there is provided a solid state relay with means for sensing a zero volts crossing point in a waveform, said solid state relay including primary switching means and secondary switching means, said secondary switching means is adapted to trigger said primary switching means and to conduct an AC power supply in parallel with said primary switching means during a time interval between the switching on of a pilot switch and the AC power supply voltage amplitude reaching a predetermined minimum value at which the primary switch means takes over full conduction of the AC power supply.

Preferably, said secondary switch means comprises a pair of gate-source coupled Field Effect Transistors (FETs) having their respective drains connected to the gates of the thyristor means of the primary switch means and first and second diode means connected between the gates of said thyristor means and AC supply terminals of the switch circuit.

Embodiments of the present invention will now be described, by way of example only, with reference to the accompanying drawings of which:
Fig. 1 shows a first embodiment of an SSR circuit in accordance with the present invention;
Fig. 2 shows an embodiment of an SSR circuit similar to that shown in Fig. 1 but with a modified control circuit and additional connections to the switch circuit;
Fig. 3 shows an embodiment of an SSR circuit similar to that shown in Fig. 2 but with the Schottky diodes replaced with PNP transistors;
Fig. 4 shows an embodiment of an SSR circuit similar to that shown in Fig. 2 with ferrite beads connected to the thyristors;
Fig. 5 shows an embodiment of an SSR circuit similar to that shown in Fig. 2 with ferrite beads connected to the thyristors and resistors connected in parallel with the Schottky Diodes;
Fig.6 shows a further embodiment of an SSR circuit in accordance with the present invention; and
Fig. 7 shows an embodiment of an SSR circuit similar to that shown in Fig. 6 with the Schottky diodes and Field Effect Transmitters (FETs).

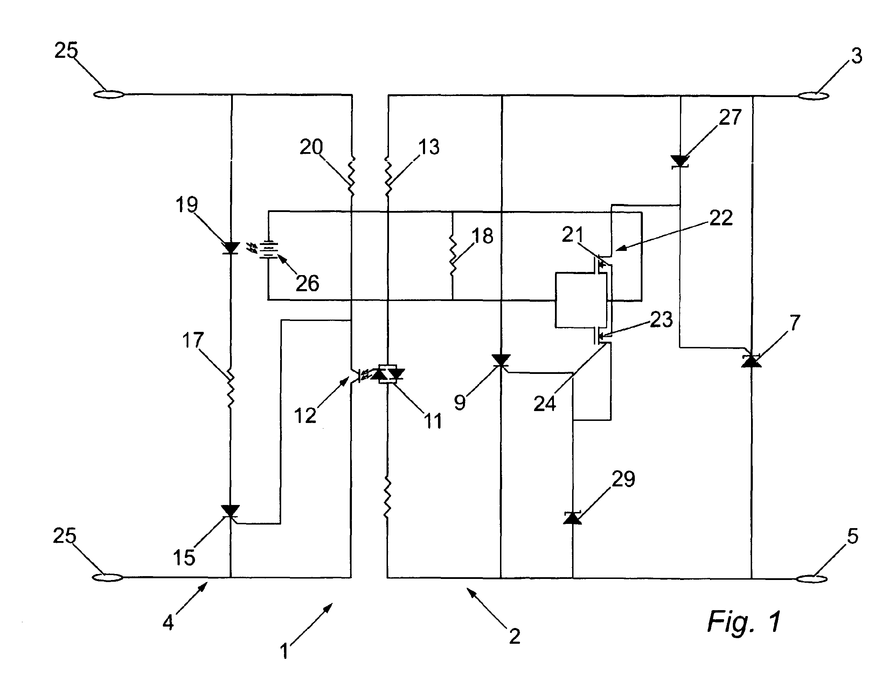

Fig. 1 shows a SSR circuit 1, comprising a switch circuit 2 and a control circuit 4. The circuits 2 and 4 are electrically isolated from one another, being coupled by first and second opto-coupling means 11/12 and 19/26.

The switch circuit 2 includes switching means comprising an inverse back-to-back pair of thyristors 7 and 9, connected in parallel between an AC input terminal 3 and an AC output terminal 5, so that operation of the thyristors 7 and 9 controls an AC power supply connected across the terminals 3 and 5.
The first opto-coupling means comprises an AC coupled, isolated opto-coupler consisting of a pair of back-to-back LEDs 11 in the switch circuit 2, optically coupled to a photo-transistor 12 in the control circuit 4. The LEDs 11 and series current-limiting resistors 13 are connected in parallel with the thyristors 7 and 9.

The second opto-coupling means comprises a photovoltaic opto-coupler consisting of an LED 19 in the control circuit 4, optically coupled to a photovoltaic cell 26 in the switch circuit 2. Alternatively, magnetic coupling, electrostatic coupling or piezoelectric coupling can be used instead of the second optical coupling means.

The operation of the thyristors 7 and 9 is controlled by the control circuit 4 and by further components of the switch circuit 2, including opto-couplers 11/12 and 19/26, a pair of gate-source coupled power MOSFETs 21 and 23 having their respective drains connected to the gates of the thyristors 7 and 9, and low Vf Schottky diodes 27 and 29, having their respective cathodes connected to the gates of the thyristors 7 and 9 and their respective anodes connected to the AC terminals 3 and 5.

The MOSFETS 21 and 23 are controlled by the photovoltaic cell 26, a bleed resistor 18 being connected in parallel with the photovoltaic cell 26 and conduct across the zero point in the AC voltage signal from a positive higher that the cut off voltage of the thyristor in the positive half of the cycle to a negative voltage lower than the voltage at which the thyristor is switched on in the negative half of the cycle.

The control circuit 4 includes a pilot thyristor 15 connected in series with the LED 19 of photovoltaic opto-coupler 19/26 and resistor 17 across input terminals 25. The photo-transistor 12 of opto-coupler 11/12 is connected in series with pull-up resistor 20, also across the terminals 25. The gate of the pilot thyristor 15 is connected to a point between the photo-transistor 12 and pull-up resistor 20. In use, a control-input voltage is applied to the terminals 25.

When the AC voltage across the AC terminals 3 and 5 is sufficiently high to cause current flow through the back-to-back LEDs 11, the photo-transistor 12 optically coupled thereto is conducting, thereby holding off the pilot thyristor 15. As the AC waveform approaches zero (in this example, 0.8 volts before zero), the photo-transistor 12 turns off, allowing the pull-up resistor 20 to conduct current into the gate of the pilot thyristor 15, turning it on. The pilot thyristor 15 then latches on, causing current to flow through the LED 19 of the photovoltaic opto-coupler 19/26. The voltage generated by the photovoltaic cell 26 turns on the MOSFETs 21 and 23, which in turn causes current to flow through the Schottky diodes 27 and 29, and turns on the thyristors 7 and 9 at about 2 volts.

The SSR of Fig. 1 provides improved zero crossing detection by sensing an approaching zero crossing at about 0.7 volts before zero. This enables pre-arming of the thyristor firing sequence and ensures switching at or very close to true zero, reducing noise by about 20dB.

The thyristors 7 and 9 require a Vf of about 1.4 volts before they will operate and a gate to cathode voltage of between 1.2 and 1.8 volts for full conduction. This creates waveform distortion which must be reduced or removed in order to achieve near-perfect zero switching.

The MOSFETs 21 and 23 act as secondary devices which assist in achieving near perfect zero switching by conducting current from near zero volts up to and beyond the point where the thyristors can achieve and take over full conduction, and also help to trigger the gates of the thyristors 7 and 9. Therefore, before the thyristors begin to conduct at 2 volts, the MOSFETs 21 and 23 are already conducting, thereby reducing distortion and noise. The noise is reduced by substantially removing the voltage step which would be caused by the thyristors switching off in the positive half of the cycle and on again in the negative half of the cycle. Voltage steps of this type are effectively square waves, which contain a large number of harmonic waves and therefore electrical noise.

In relay circuits in which the MOSFETs conducted only in the forward bias direction, the time interval between conduction of the MOSFETs can result in switching at a point in the cycle where there is a large AC current if the AC current and voltage are out of phase, which generates a large spike of noise. In such cases, it is necessary to remove the noise using a device called a snubber. In the present invention, MOSFETs 22 and 23 each can conduct in both the forward bias and reverse bias direction, therefore there is no switching between conduction from MOSFET 23 to MOSFET 22 and vice versa and no associated time delay. Therefore, the level of noise in the circuit is not affected if the AC voltage and AC current are out of phase.

The embodiment of Fig. 1 may reduce the noise level to about 48dB at 100kHz, which is just within the 50dB limit of current European standards. This residual noise is due in part to the voltage drop of about 0.2 to 0.4 volts across each of the Schottky diodes 27 and 29.

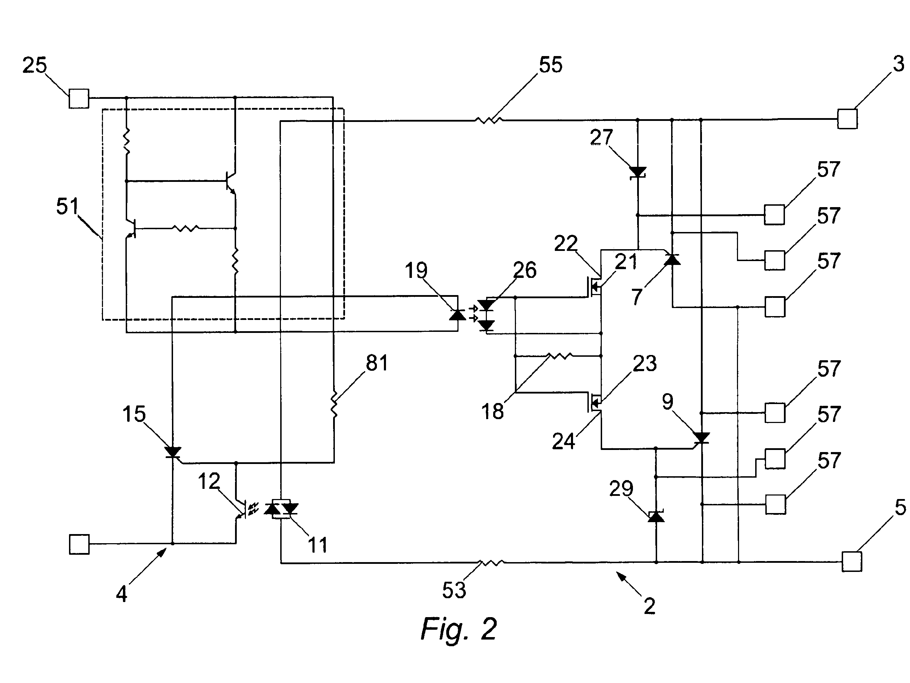

Figs. 2 to 5 provide additional means for noise reduction in circuits similar to that shown in Fig.1. In the following embodiment, identical reference numerals are used when describing identical components.

Fig. 2 shows an embodiment of the present invention similar to that shown in Fig. 1 but with modifications to the control circuit 4 and the switch circuit 2. In this example the LED 19 is connected to the pilot thyristor 15 and a drive circuit 51. The switch circuit is provided with additional resistors 53, 55 each of which is in series with the back-to-back LEDs 11. The switch circuit 2 is further provided with additional connectors 57 used to obtain electrical signals from a variety of points on the switch circuit 2.

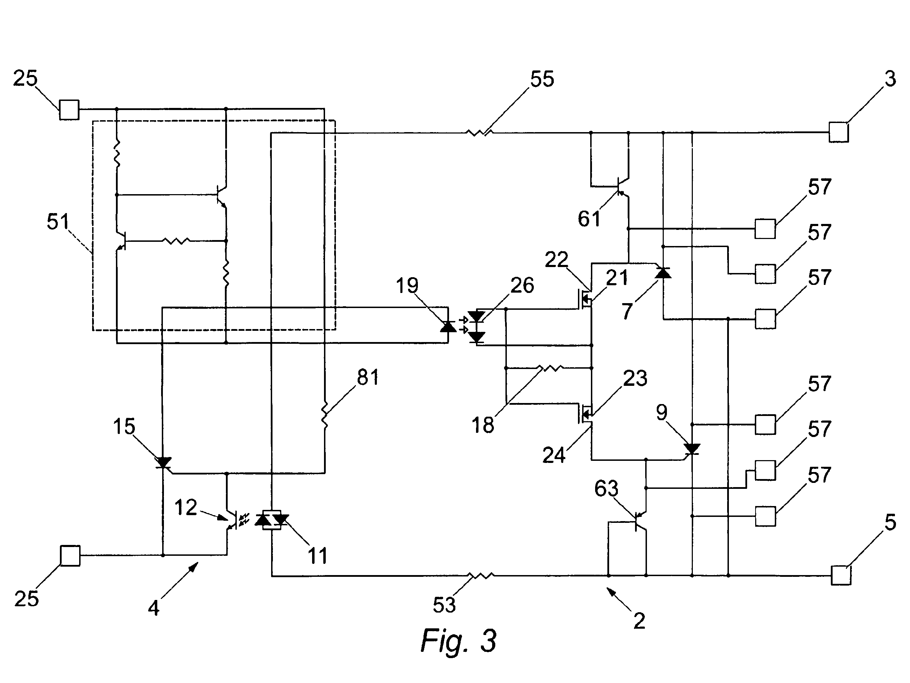

Fig. 3 shows an SSR Circuit similar to that given in Fig. 2 which uses Silicon PNP transistors 61, 63 in place of the Schottky diodes 27, 29 shown in Fig. 2.

It will be appreciated that any other component functioning in a similar way to the Schottky diodes 27, 29 may be used in their place in circuit. In particular, transistors such as PNP Germanium transistors NPN Germanium transistors and NPN Silicon transistors. In addition, diodes such as Germanium diodes may be used.

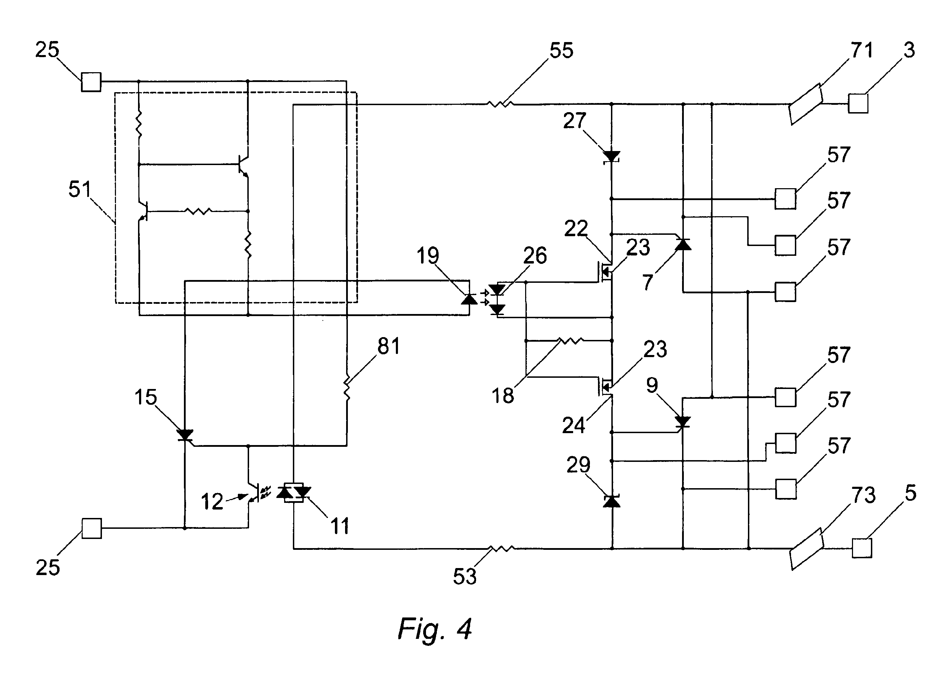

Fig 4. shows a circuit similar to that of Fig. 2 but with ferrite beads 71, 73 positioned on the leads 3 and 5 of thyristors 7 and 9 respectively. The ferrite beads act as a filter for high frequency noise and as such reduce the total noise in the circuit by 6db in comparison to similar circuits which do not contain the ferrite beads.

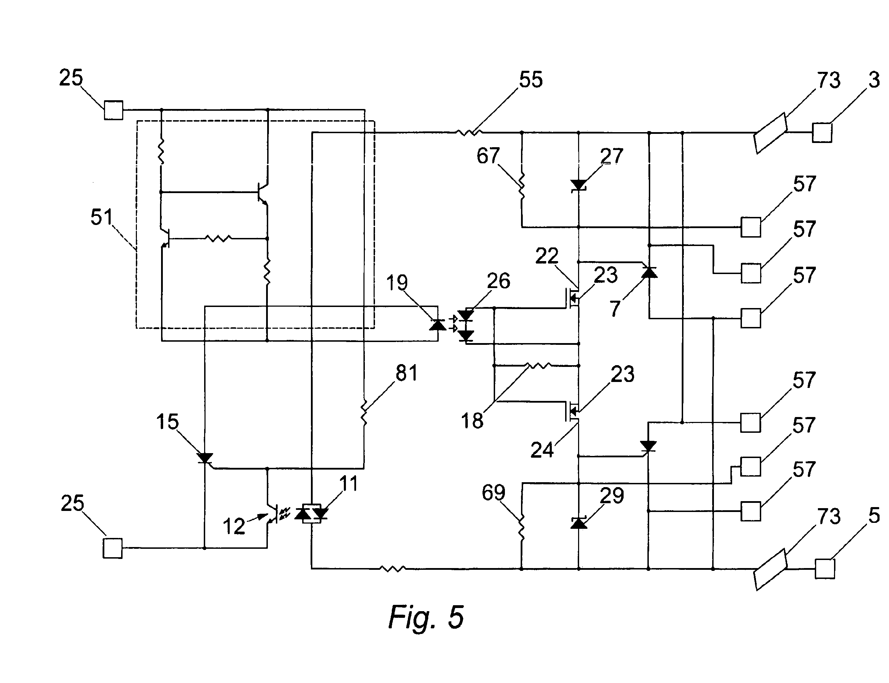

The embodiment of the present invention in Fig. 5 shows a circuit similar to that shown in Fig. 2. In this example, resistors 67, 69 have been connected in parallel with Schottky diodes 27 and 29. Ferrite beads 71, 73 are also provided as in Fig.4. The combination of resistors 67, 69 and ferrite beads 71, 73 further reduces the noise in the circuit by acting as a filter. In particular the ferrite beads act to filter out high frequency noise from the circuit. In this circuit, noise can be reduced by around 18 db in comparison to similar circuits which do not contain the ferrite beads 71,73 or the resistors 67, 69.

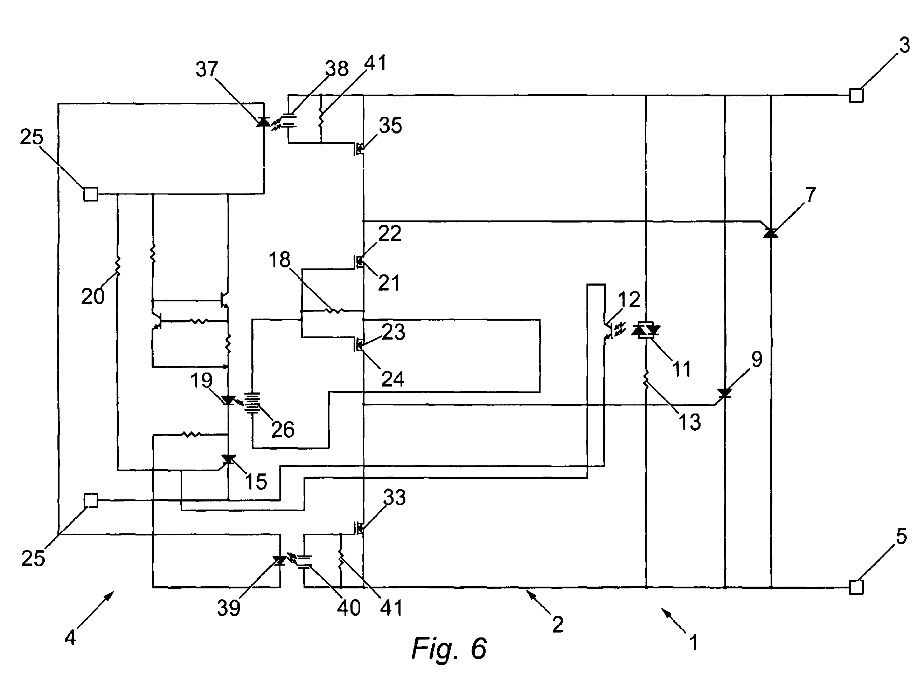

Fig. 6 shows a further embodiment of the invention, similar to that of Fig. 1, in which like components are designated by like reference numerals.

In Fig. 6, the Schottky diodes 27 and 29 of Fig. 1 have been replaced by FETs 33 and 35 (suitably MOSFETs) which are functionally equivalent to the diodes 27 and 29 of Fig. 1; i.e. the FETs 33 and 35 act as diodes. Operation of the FETs 33 and 35 is controlled by additional photovoltaic opto-couplers 37/38 and 39/40, each comprising an LED 37 and 39 in the control circuit 4 and a photovoltaic cell 38 and 40 in the switch circuit 2. A resistor 41 is connected across each of the photovoltaic cells 38 and 40. The control circuit 4 is configured such that suitable voltages are generated across each of the LEDs 19, 37 and 39 when the pilot thyristor 15 is turned on.

In this embodiment, when the pilot thyristor 15 latches, it causes current to flow through the LEDs 19, 37 and 39 of each of the three photovoltaic opto-couplers 19/26, 37/38 and 39/40. The voltages generated by the photovoltaic cells 26, 38 and 40 turn cn the MOSFETs 21 and 23 (as before) and the FETs 33 and 35, so that current flows through the FET "diodes" 33 and 35 until the voltage across them is sufficiently high to turn on the thyristors 7 and 9.

The FETs 33 and 35 are selected to have low "Rds On", so as to achieve a voltage drop of 0.1 volts or less. By this means, switching of the thyristors 7 and 9 occurs within 0.1 volts of true zero of the AC waveform and the noise generated is reduced to 15dB or less.

Control of the device may be effected by an a.c. or d.c. voltage applied to the input terminals 25, typically having a value in the range 3 - 32 volts for a d.c. voltage.

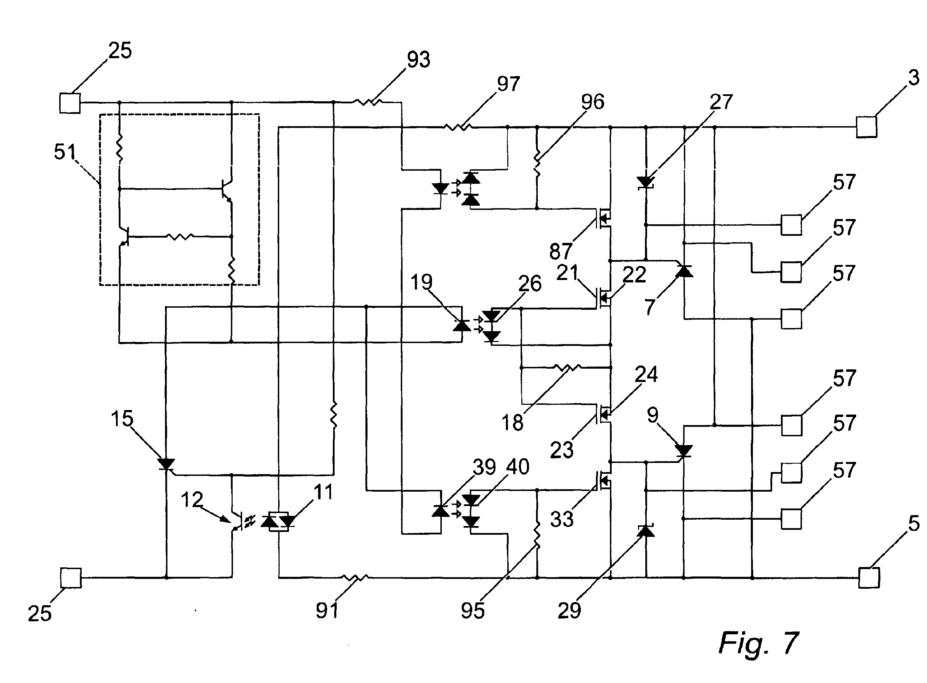

Fig. 7 shows an embodiment of the present invention similar to that shown in Fig. 6. In this example Schottky Diodes 27, 29 are retained in the circuit along with the FETs 33, 35.

Improvements and modifications may be incorporated without departing from the scope of the invention.

## Claims

1. A solid state relay (1) comprising:
a switch circuit (2) including primary switch means for controlling an AC power supply (3,5), said primary switch means including thyristor means (7,9); and
a control circuit (4) for receiving a control input signal which controls the operation of said primary switch means; wherein
said switch circuit (2) and said control circuit (4) are electrically isolated from one another and coupled to one another by first and second coupling means (11,12, 19,26),
said first coupling means (11,12) being optical coupling means comprising first light emitting means (11) in said switch circuit (2) and optical switch means (12) in said control circuit (4), responsive to said first light emitting means (11),
and said second coupling means (19,26) comprising second signal emitting means (19) in said control circuit (4) and signal receiving means (26) in said switch circuit (2) responsive to said second signal emitting means (26);
said control circuit (4) includes pilot switch means (15) responsive to said optical switch means (12) and said pilot switch means (15) controls the operation of said second signal emitting means (19);
the light emitted by said first light emitting means (11) varies with the AC supply voltage (3,5) such that said pilot switch (15) switches on said second signal emitting means (19) at a predetermined AC supply voltage amplitude as said AC supply voltage (3,5) approaches zero; and
said signal receiving means (26) operates in response to said second light emitting means (19) to actuate said primary switching means (7,9); and wherein
the switch circuit (2) includes secondary switch means (21,23) responsive to said signal receiving means (26) and adapted to trigger said primary switch means (7,9) and to conduct said AC power supply (3,5) in parallel with said primary switching means (7,9) during a time interval between the switching on of said pilot switch (15) and the AC power supply (3,5) voltage amplitude reaching a predetermined minimum value at which the primary switch means takes over full conduction of the AC power supply (3,5).

2. A solid state relay as claimed in claim 1 wherein said primary switching means comprises a pair of inverse back-to-back thyristors (7,9).

3. A solid state relay as claimed in claim 1 wherein said primary switching means comprises a pair of inverse back-to-back alternistors.

4. A solid state relay as claimed in claim 1 wherein said primary switching means comprises a pair of inverse back-to-back triacs.

5. A solid state relay as claimed in any preceding claim wherein the second coupling means is an optical coupling or a magnetic coupling or an electrostatic coupling or a piezoelectric coupling.

6. A solid state relay as claimed in any preceding claim wherein said light emitting means (11,19) are Light Emitting Diodes (LEDs).

7. A solid state relay as claimed in any preceding claim wherein said optical switch (12) means comprises a photo-transistor.

8. A solid state relay as claimed in any preceding claim wherein said second coupling means is an opto-coupling means, said second signal emitting means (19) is a light emitting means and said signal receiving means (26) is a photosensitive means.

9. A solid state relay as claimed in claim 8 wherein said photosensitive means comprises a photovoltaic cell (26).

10. A solid state relay as claimed in any preceding claim wherein said pilot switch means (15) comprises a thyristor.

11. A solid state relay as claimed in any preceding claim wherein said secondary switch means (21,23) comprises a pair of gate-source coupled Field Effect Transistors (FETs) having their respective drains connected to the gates of the thyristor means (7,9) of the primary switch means and first and second diode means (27,29) connected between the gates of said thyristor means (7,9) and AC supply terminals (3,5) of the switch circuit (2).

12. A solid state relay as claimed in any claim 11 wherein the operation of said FETs (21,23) is controlled by said signal receiving means (26).

13. A solid state relay as claimed in any claim 11 or claim 12 wherein said FETs (21,23) are power Metal Oxide Semiconductor Field Effect Transistors.

14. A solid state relay as claimed in any of claims 11 to 13 wherein said diode means (27,29) comprise Schottky diodes.

15. A solid state relay as claimed in any of claims 11 to 14 wherein said diode means comprise transistors (33,35), the operation of which is controlled by further optical coupling means (37,38,39,40) each comprising light emitting means (37,39) in the control circuit (4), the operation of which is controlled by said pilot switch means (15), and photo-sensitive means (38,40) (preferably a photovoltaic cell) in the switch circuit (2).

16. A solid state relay with means for sensing a zero volts crossing point in a waveform, said solid state relay including primary switching means (7,9) and secondary switching means (21,23), said secondary switching means (21,23) is adapted to trigger said primary switching means (7,9) and to conduct an AC power supply (3,5) in parallel with said primary switching means (7,9) during a time interval between the switching on of a pilot switch (15) and the AC power supply voltage (3,5) amplitude reaching a predetermined minimum value at which the primary switch means (7,9) takes over full conduction of the AC power supply (3,5).

17. A solid state relay as claimed in claim 16 wherein, said secondary switch means (21,23) comprises a pair of gate-source coupled Field Effect Transistors (FETs) having their respective drains connected to the gates of the thyristor means (7,9) of the primary switch means and first and second diode means (27,29) connected between the gates of said thyristor means (7,9) and AC supply terminals (3,5) of the switch circuit (2).

## Patentansprüche

1. Ein Halbleiterrelais (1), das Folgendes beinhaltet:
einen Schalterschaltkreis (2) einschließlich eines primären Schaltermittels zum Steuern einer Wechselstromversorgung (3, 5), wobei das primäre Schaltermittel ein Thyristormittel (7, 9) umfasst; und
einen Steuerschaltkreis (4) zum Empfangen eines Steuereingangssignals, das den Betrieb des primären Schaltermittels steuert; wobei
der Schalterschaltkreis (2) und der Steuerschaltkreis (4) elektrisch voneinander isoliert sind und durch ein erstes und ein zweites Kopplungsmittel (11, 12, 19, 26) aneinander gekoppelt sind,
wobei das erste Kopplungsmittel (11, 12) ein optisches Kopplungsmittel ist, das ein erstes Licht emittierendes Mittel (11) in dem Schalterschaltkreis (2) und ein optisches Schaltermittel (12) in dem Steuerschaltkreis (4), das auf das erste Licht emittierende Mittel (11) reagiert, beinhaltet,
und das zweite Kopplungsmittel (19, 26) ein zweites Signal emittierendes Mittel (19) in dem Steuerschaltkreis (4) und ein Signal empfangendes Mittel (26) in dem Schalterschaltkreis (2), das auf das zweite Signal emittierende Mittel (26) reagiert, beinhaltet;
wobei der Steuerschaltkreis (4) ein Pilotschaltermittel (15) umfasst, das auf das optische Schaltermittel (12) reagiert, und das Pilotschaltermittel (15) den Betrieb des zweiten Signal emittierenden Mittels (19) steuert;
wobei das von dem ersten Licht emittierenden Mittel (11) emittierte Licht mit der Wechselstromversorgungsspannung (3, 5) so variiert, dass der Pilotschalter (15) das zweite Signal emittierende Mittel (19) bei einer zuvor festgelegten Amplitude der Wechselstromversorgungsspannung anschaltet, wenn sich die Wechselstromversorgungsspannung (3, 5) null annähert; und
wobei das Signal empfangende Mittel (26) als Reaktion auf das zweite Licht emittierende Mittel (19) arbeitet, um das primäre Schaltmittel (7, 9) zu betätigen; und wobei
der Schalterschaltkreis (2) ein sekundäres Schaltermittel (21, 23) umfasst, das auf das Signal empfangende Mittel (26) reagiert und angepasst ist, um das primäre Schaltermittel (7, 9) auszulösen und die Wechselstromversorgung (3, 5) während eines Zeitintervalls zwischen dem Anschalten des Pilotschalters (15) und der Zeit, wenn die Spannungsamplitude der Wechselstromversorgung (3, 5) einen zuvor festgelegten minimalen Wert erreicht, zu welchem Zeitpunkt das primäre Schaltermittel die volle Leitung der Wechselstromversorgung (3, 5) übernimmt, parallel zu dem primären Schaltermittel (7, 9) zu leiten.

2. Halbleiterrelais gemäß Anspruch 1, wobei das primäre Schaltmittel ein Paar inverse antiparallel geschaltete Thyristoren (7, 9) beinhaltet.

3. Halbleiterrelais gemäß Anspruch 1, wobei das primäre Schaltmittel ein Paar inverse antiparallel geschaltete Alternistoren beinhaltet.

4. Halbleiterrelais gemäß Anspruch 1, wobei das primäre Schaltmittel ein Paar inverse antiparallel geschaltete Triacs beinhaltet.

5. Halbleiterrelais gemäß einem der vorhergehenden Ansprüche,
wobei das zweite Kopplungsmittel eine optische Kopplung oder eine magnetische Kopplung oder eine elektrostatische Kopplung oder eine piezoelektrische Kopplung ist.

6. Halbleiterrelais gemäß einem der vorhergehenden Ansprüche,
wobei das Licht emittierende Mittel (11, 19) Licht emittierende Dioden (LEDs) sind.

7. Halbleiterrelais gemäß einem der vorhergehenden Ansprüche,
wobei das Mittel des optischen Schalters (12) einen Phototransistor beinhaltet.

8. Halbleiterrelais gemäß einem der vorhergehenden Ansprüche,
wobei das zweite Kopplungsmittel ein Optokopplungsmittel ist, das zweite Signal emittierende Mittel (19) ein Licht emittierendes Mittel ist und das Signal empfangende Mittel (26) ein photoempfindliches Mittel ist.

9. Halbleiterrelais gemäß Anspruch 8, wobei das photoempfindliche Mittel ein Photoelement (26) beinhaltet.

10. Halbleiterrelais gemäß einem der vorhergehenden Ansprüche,
wobei das Pilotschaltermittel (15) einen Thyristor beinhaltet.

11. Halbleiterrelais gemäß einem der vorhergehenden Ansprüche,
wobei das sekundäre Schaltermittel (21, 23) ein Paar Steuerelektrode-Quellenelektrode-gekoppelte Feldeffekttransistoren (FETs) beinhaltet, deren jeweilige Senkenelektroden mit den Steuerelektroden des Thyristormittels (7, 9) des primären Schaltermittels und einem ersten und zweiten Diodenmittel (27, 29), die zwischen den Steuerelektroden des Thyristormittels (7, 9) und den Wechselstromversorgungsterminals (3, 5) des Schalterschaltkreises (2) verbunden sind, verbunden sind.

12. Halbleiterrelais gemäß Anspruch 11, wobei der Betrieb der FETs (21, 23) durch das Signal empfangende Mittel (26) gesteuert wird.

13. Halbleiterrelais gemäß Anspruch 11 oder Anspruch 12, wobei die FETs (21, 23) Leistungs-Metalloxid-Halbleiter-Feldeffekttransistoren sind.

14. Halbleiterrelais gemäß einem der Ansprüche 11 bis 13, wobei das Diodenmittel (27, 29) Schottky-Dioden beinhaltet.

15. Halbleiterrelais gemäß einem der Ansprüche 11 bis 14, wobei das Diodenmittel Transistoren (33, 35) beinhaltet, deren Betrieb durch weitere optische Kopplungsmittel (37, 38, 39, 40) gesteuert wird, die jeweils ein Licht emittierendes Mittel (37, 39) in dem Steuerschaltkreis (4), dessen Betrieb von dem Pilotschaltermittel (15) gesteuert wird, und ein photoempfindliches Mittel (38, 40) (vorzugsweise ein Photoelement) in dem Schalterschaltkreis (2) beinhalten.

16. Ein Halbleiterrelais mit einem Mittel zum Erkennen eines Nullvolt-Durchgangspunktes in einer Wellenform, wobei das Halbleiterrelais ein primäres Schaltmittel (7, 9) und ein sekundäres Schaltmittel (21, 23) umfasst, wobei das sekundäre Schaltmittel (21, 23) angepasst ist, um das primäre Schaltmittel (7, 9) auszulösen und eine Wechselstromversorgung (3, 5) während eines Zeitintervalls zwischen dem Anschalten eines Pilotschalters (15) und der Zeit, wenn die Spannungsamplitude der Wechselstromversorgung (3, 5) einen zuvor festgelegten minimalen Wert erreicht, zu welchem Zeitpunkt das primäre Schaltermittel (7, 9) die volle Leitung der Wechselstromversorgung (3, 5) übernimmt, parallel zu dem primären Schaltmittel (7, 9) zu leiten.

17. Halbleiterrelais gemäß Anspruch 16, wobei das sekundäre Schaltermittel (21, 23) ein Paar Steuerelektrode-Quellenelektrode-gekoppelte Feldeffekttransistoren (FETs) beinhaltet, deren jeweilige Senkenelektroden mit den Steuerelektroden des Thyristormittels (7, 9) des primären Schaltermittels und einem ersten und zweiten Diodenmittel (27, 29) zwischen den Steuerelektroden des Thyristormittels (7, 9) und der Wechselstromversorgungsterminals (3, 5) des Schalterschaltkreises (2) verbunden sind, verbunden sind.

## Revendications

1. Un relais à semi-conducteurs (1) comprenant :
un circuit de commutation (2) incluant un moyen de commutation primaire destiné à commander une alimentation électrique CA (3, 5), ledit moyen de commutation primaire incluant un moyen formant thyristor (7, 9) ; et
un circuit de commande (4) destiné à recevoir un signal d'entrée de commande qui commande le fonctionnement dudit moyen de commutation primaire ; dans lequel
ledit circuit de commutation (2) et ledit circuit de commande (4) sont isolés électriquement l'un de l'autre et couplés l'un à l'autre par des premiers et deuxièmes moyens de couplage (11, 12,19,26),
lesdits premiers moyens de couplage (11,12) étant des moyens de couplage optique comprenant un premier moyen émetteur de lumière (11) dans ledit circuit de commutation (2) et un moyen de commutation optique (12) dans ledit circuit de commande (4), sensible audit premier moyen émetteur de lumière (11),
et lesdits deuxièmes moyens de couplage (19, 26) comprenant un deuxième moyen émetteur de signal (19) dans ledit circuit de commande (4) et un moyen récepteur de signal (26) dans ledit circuit de commutation (2) sensible audit deuxième moyen émetteur de signal (26) ;
ledit circuit de commande (4) inclut un moyen de commutation pilote (15) sensible audit moyen de commutation optique (12) et ledit moyen de commutation pilote (15) commande le fonctionnement dudit deuxième moyen émetteur de signal (19) ;
la lumière émise par ledit premier moyen émetteur de lumière (11) varie avec la tension d'alimentation CA (3, 5) de telle sorte que ledit commutateur pilote (15) met sous tension ledit deuxième moyen émetteur de signal (19) à une amplitude de tension d'alimentation CA prédéterminée quand ladite tension d'alimentation CA (3, 5) approche de zéro ; et
ledit moyen récepteur de signal (26) fonctionne en réponse audit deuxième moyen émetteur de lumière (19) pour actionner ledit moyen de commutation primaire (7, 9) ; et dans lequel
le circuit de commutation (2) inclut un moyen de commutation secondaire (21, 23) sensible audit moyen récepteur de signal (26) et adapté pour déclencher ledit moyen de commutation primaire (7, 9) et pour faire passer en conduction ladite alimentation électrique CA (3, 5) en parallèle avec ledit moyen de commutation primaire (7, 9) durant un intervalle de temps entre le moment de la mise sous tension dudit commutateur pilote (15) et le moment où l'amplitude de tension de l'alimentation électrique CA (3, 5) atteint une valeur minimum prédéterminée à laquelle le moyen de commutation primaire reprend la pleine conduction de l'alimentation électrique CA (3, 5).

2. Un relais à semi-conducteurs tel que revendiqué dans la revendication 1 dans lequel ledit moyen de commutation primaire comprend une paire de thyristors en opposition inverses (7, 9).

3. Un relais à semi-conducteurs tel que revendiqué dans la revendication 1 dans lequel ledit moyen de commutation primaire comprend une paire d'alternistors en opposition inverses.

4. Un relais à semi-conducteurs tel que revendiqué dans la revendication 1 dans lequel ledit moyen de commutation primaire comprend une paire de triacs en opposition inverses.

5. Un relais à semi-conducteurs tel que revendiqué dans n'importe quelle revendication précédente, dans lequel le deuxième moyen de couplage est un couplage optique ou un couplage magnétique ou un couplage électrostatique ou un couplage piézoélectrique.

6. Un relais à semi-conducteurs tel que revendiqué dans n'importe quelle revendication précédente dans lequel lesdits moyens émetteurs de lumière (11, 19) sont des diodes électroluminescentes (DEL).

7. Un relais à semi-conducteurs tel que revendiqué dans n'importe quelle revendication précédente dans lequel ledit moyen de commutation optique (12) comprend un photo-transistor.

8. Un relais à semi-conducteurs tel que revendiqué dans n'importe quelle revendication précédente dans lequel ledit deuxième moyen de couplage est un moyen d'opto-couplage, ledit deuxième moyen émetteur de signal (19) est un moyen émetteur de lumière et ledit moyen récepteur de signal (26) est un moyen photosensible.

9. Un relais à semi-conducteurs tel que revendiqué dans la revendication 8 dans lequel ledit moyen photosensible comprend une cellule photovoltaïque (26).

10. Un relais à semi-conducteurs tel que revendiqué dans n'importe quelle revendication précédente dans lequel ledit moyen de commutation pilote (15) comprend un thyristor.

11. Un relais à semi-conducteurs tel que revendiqué dans n'importe quelle revendication précédente dans lequel ledit moyen de commutation secondaire (21, 23) comprend une paire de transistors à effet de champ (TEC) couplés à la grille-source dont les drains respectifs sont connectés aux grilles du moyen formant thyristor (7, 9) du moyen de commutation primaire et des premier et deuxième moyens formant diodes (27, 29) connectés entre les grilles dudit moyen formant thyristor (7, 9) et les terminaux d'alimentation CA (3, 5) du circuit de commutation (2).

12. Un relais à semi-conducteurs tel que revendiqué dans la revendication 11, dans lequel le fonctionnement desdits TEC (21, 23) est commandé par ledit moyen récepteur de signal (26).

13. Un relais à semi-conducteurs tel que revendiqué dans la revendication 11 ou la revendication 12 dans lequel lesdits TEC (21, 23) sont des transistors de puissance à effet de champ métal/oxyde/semi-conducteur.

14. Un relais à semi-conducteurs tel que revendiqué dans n'importe lesquelles des revendications 11 à 13 dans lequel lesdits moyens formant diodes (27, 29) comprennent des diodes Schottky.

15. Un relais à semi-conducteurs tel que revendiqué dans n'importe lesquelles des revendications 11 à 14 dans lequel lesdits moyens formant diodes comprennent des transistors (33, 35) dont le fonctionnement est commandé par des moyens de couplage optique supplémentaires (37, 38, 39, 40) comprenant chacun des moyens émetteurs de lumière (37, 39) dans le circuit de commande (4), dont le fonctionnement est commandé par ledit moyen de commutation pilote (15), et des moyens photo-sensibles (38, 40) (de préférence une cellule photovoltaïque) dans le circuit de commutation (2).

16. Un relais à semi-conducteurs muni d'un moyen destiné à capter un point de passage à zéro volt dans une forme d'onde, ledit relais à semi-conducteurs incluant un moyen de commutation primaire (7, 9) et un moyen de commutation secondaire (21, 23), ledit moyen de commutation secondaire (21, 23) est adapté pour déclencher ledit moyen de commutation primaire (7, 9) et pour faire passer en conduction une alimentation électrique CA (3, 5) en parallèle avec ledit moyen de commutation primaire (7, 9) durant un intervalle de temps entre le moment de la mise sous tension d'un commutateur pilote (15) et le moment où l'amplitude de tension de l'alimentation électrique CA (3, 5) atteint une valeur minimum prédéterminée à laquelle le moyen de commutation primaire (7, 9) reprend la pleine conduction de l'alimentation électrique CA (3, 5).

17. Un relais à semi-conducteurs tel que revendiqué dans la revendication 16 dans lequel ledit moyen de commutation secondaire (21, 23) comprend une paire de transistors à effet de champ (TEC) couplés à la grille-source dont les drains respectifs sont connectés aux grilles du moyen formant thyristor (7, 9) du moyen de commutation primaire et des premier et deuxième moyens formant diodes (27, 29) connectés entre les grilles dudit moyen formant thyristor (7, 9) et les terminaux d'alimentation CA (3, 5) du circuit de commutation (2).
